# EUROPEAN PATENT SPECIFICATION

(11) **EP 4 545 992 B1**
(45) Date of publication and mention of the grant of the patent: **16.09.2026**
(21) Application number: 23851273.5
(22) Date of filing: 28.04.2023
(51) Int. Cl.: G01R 31/385, H04Q 9/00

(54) **BATTERY TEST METHOD AND APPARATUS, AND ELECTRONIC DEVICE AND COMPUTER-READABLE STORAGE MEDIUM**
BATTERIETESTVERFAHREN UND -VORRICHTUNG SOWIE ELEKTRONISCHE VORRICHTUNG UND COMPUTERLESBARES SPEICHERMEDIUM
APPAREIL ET PROCÉDÉ DE TEST DE BATTERIE, DISPOSITIF ÉLECTRONIQUE ET SUPPORT DE STOCKAGE LISIBLE PAR ORDINATEUR

(30) Priority: 10.08.2022 CN 202210956298
(43) Date of publication of application: 30.04.2025
(73) Proprietor: Contemporary Amperex Technology Co., Limited, Ningde, Fujian 352100 (CN)
(72) Inventor: LIAN, Dengwei, Ningde, Fujian 352100 (CN); CHEN, Chen, Ningde, Fujian 352100 (CN); ZHAO, Tong, Ningde, Fujian 352100 (CN); LI, Yanghu, Ningde, Fujian 352100 (CN)
(74) Representative: Lorenz Seidler Gossel Part. mbB
(86) International application number: PCT/CN2023/091836
(87) International publication number: WO 2024/032043

(56) References cited:
- CN-A- 102 386 445
- CN-A- 105 093 112
- CN-A- 107 117 048
- CN-A- 109 756 397
- CN-A- 111 025 160
- CN-A- 111 762 497
- CN-A- 114 114 058
- US-A1- 2006 017 582
- US-A1- 2014 374 475
- US-A1- 2017 176 539

## Description

### TECHNICAL FIELD

The present application relates to the technical field of battery testing, and in particular to a battery testing method, an electronic device, and a computer-readable storage medium.

### BACKGROUND

At present, it is necessary to use the whole-vehicle EOL (End Of Line) testing device before batteries come off the line, so that the batteries can better meet the subsequent daily use requirements of the whole vehicles after leaving the factory. Examples of battery testing devices are disclosed in US 2017/176539 A1 and US 2014/374475 A1.

The current EOL test takt is long, and in order to meet the test demand, it is necessary to reserve more testing stations during the construction of the stay wire. This approach then leads to the problems of high space requirements and low testing efficiency.

### SUMMARY OF THE INVENTION

In view of this, the purpose of the embodiments of the present application is to provide a battery testing method, an electronic device, and a computer-readable storage medium, so as to alleviate the problem of low battery testing efficiency in the prior art.

In a first aspect, the embodiments of the present application provide a battery testing method, including: receiving battery data of a battery to be tested by means of wireless communication; and testing the battery data according to a test baseline corresponding to the battery to be tested to obtain a test result.

In an optional implementation, the battery data includes at least two items to be tested, and the test baseline includes a specification interval corresponding to each item to be tested; and said testing the battery data according to a test baseline corresponding to the battery to be tested to obtain a test result includes: comparing each item to be tested with the corresponding specification interval in the test baseline to determine a test result for each item to be tested.

In an optional implementation, the battery data includes at least one of a maximum voltage of the battery to be tested, a minimum voltage of the battery to be tested, a battery cell voltage difference in the battery to be tested, a maximum temperature of the battery to be tested, a minimum temperature of the battery to be tested, a battery cell temperature difference in the battery to be tested, water inlet and outlet temperatures of the battery to be tested, and a charging port temperature of the battery to be tested.

In an optional implementation, the method further includes: sending the test result to a communication device, wherein the communication device is a device for transmitting the battery data of the battery to be tested.

In an optional implementation, before said receiving battery data of a battery to be tested by means of wireless communication, the method further includes: receiving a connection request of a communication device, wherein the communication device is used for transmitting the battery data of the battery to be tested; and establishing a testing thread for the battery to be tested after receiving the connection request, wherein the testing thread is used for testing the battery to be tested.

In an optional implementation, said establishing a testing thread for the battery to be tested includes: if the communication device is used for sending battery data of multiple groups of batteries to be tested, establishing one testing thread separately for each group of batteries to be tested in the multiple groups of batteries to be tested; or establishing one testing thread for the multiple groups of batteries to be tested.

In an optional implementation, the method further includes: acquiring product information for the battery to be tested; and determining, according to the product information, the test baseline for testing the battery to be tested.

In an optional implementation, said acquiring product information for the battery to be tested includes: receiving the product information for the battery to be tested by means of wireless communication.

The method is applied to an electronic device on which a testing program and a monitoring program are run, the testing program being used for testing the battery to be tested; and the method further includes: sending a heartbeat packet to the monitoring program through the testing program; and controlling, through the monitoring program, the testing program to restart if the monitoring program fails to receive the heartbeat packet sent by the testing program for a set length of time.

In an optional implementation, said sending a heartbeat packet to the monitoring program through the testing program includes: sending the heartbeat packet to the monitoring program according to a set time pattern through the testing program.

For illustrative purposes only and not forming part of the claimed invention, a battery testing apparatus may be provided, comprising a first receiving module for receiving battery data of a battery to be tested by means of wireless communication, and a testing module for testing the battery data according to a test baseline corresponding to the battery to be tested to obtain a test result.

In a second aspect, the embodiments of the present application provide an electronic device, including: a processor and a memory storing machine-readable instructions that are executable by the processor, wherein when the electronic device is run, the machine-readable instructions are executed by the processor to perform the steps of the method as described above.

In a third aspect, the embodiments of the present application provide a computer-readable storage medium having a computer program stored thereon, wherein the computer program, when run by a processor, executes the steps of the method as described above.

In a fourth aspect, the embodiments of the present application provide a computer program product, including computer program instructions, wherein the computer program instructions, when read and run by a processor, execute the method as described above.

In the fifth aspect, the embodiments of the present application provide a testing system, including: an electronic device and a testing device, wherein the electronic device is used for executing the steps in the battery testing method as described above; and the testing device is used for wired connection with the battery to be tested or a vehicle in which the battery to be tested is mounted, so as to perform an endurance test on the battery to be tested.

In an optional implementation, the testing device is further used for wired connection with the battery to be tested or the vehicle in which the battery to be tested is mounted after obtaining the test result of the battery to be tested from the electronic device, so as to perform the endurance test on the battery to be tested.

The battery testing method, the electronic device, and the computer-readable storage medium provided in the embodiments of the present application use a wireless testing approach to send battery data of the battery to be tested to one end of testing the battery by means of wireless transmission, so that the testing of this battery data can be realized without the need for the battery to be tested or the vehicle in which the battery is mounted to be at the testing station and pulling the wires for the battery or the whole vehicle in which the battery is mounted one by one, thus reducing the need for testing stations for battery testing and also being able to improve the efficiency of battery testing.

In order to make the above objectives, features and advantages of the present application more obvious and easy to understand, the following embodiments, together with the accompanying drawings, are described in detail as follows.

### BRIEF DESCRIPTION OF DRAWINGS

To more clearly describe the technical solutions of the embodiments of the present application, the drawings to be used in the embodiments will be briefly introduced below, and it should be understood that the following drawings only show some embodiments of the present application, and therefore should not be considered as limiting the scope of the present application. For those of ordinary skills in the art, other relevant drawings may also be obtained based on these drawings without creative efforts.
Fig. 1 is a schematic diagram of environmental interaction of the environment where a testing system for a battery testing method provided by the embodiments of the present application is located;
Fig. 2 is a schematic block diagram of an electronic device provided by the embodiments of the present application;
Fig. 3 is a flowchart of a battery testing method provided by the embodiments of the present application;
Fig. 4 is a partial flowchart of the battery testing method provided by the embodiments of the present application;
Fig. 5 is a another partial flowchart of the battery testing method provided by the embodiments of the present application;
Fig. 6 is a yet another partial flowchart of the battery testing method provided by the embodiments of the present application;
Fig. 7 is a partial schematic diagram of the battery testing method provided by the embodiments of the present application;
Fig. 8 is another partial schematic diagram of the battery testing method provided by the embodiments of the present application; and
Fig. 9 is a schematic diagram of functional modules of a battery testing apparatus for illustrative purposes only.

### DETAILED DESCRIPTION

The technical solutions in the embodiments of the present application will be described below in conjunction with the accompanying drawings in the embodiments of the present application.

It should be noted that similar symbols and letters denote similar items in the following accompanying drawings, so that once an item is defined in one of the accompanying drawings, it needs not to be further defined and explained in the subsequent drawings. At the same time, in the description of the present application, the terms "first", "second", etc., are used only to distinguish the description, and are not to be understood as indicating or implying relative importance.

In order to enable the produced batteries to meet the subsequent daily use requirements of the whole vehicle after leaving the factory, the batteries usually need to be tested using EOL electronic devices before they are taken off the production line.

The inventors of the present application have learned from the study of the current situation that when the EOL electronic device tests a battery that needs to be tested, it is necessary to provide a testing station for the vehicle in which the battery is mounted, and because of the relatively large size of the vehicle, the occupied space required for testing each battery is relatively large. The need for a testing station results in the need to first complete testing of a previously tested battery before the connection to the EOL electronic device could be implemented and then testing could be performed. In addition to the large amount of space required for this testing approach, the time required for testing is also relatively high.

Based on this, the battery testing method, the electronic device, the computer-readable storage medium, and the computer program product provided by the present application can transmit battery data of the battery to be tested by means of wireless transmission, and can also transmit the test result by means of wireless transmission. The battery testing method, the electronic device, the computer-readable storage medium, and the computer program product provided by the present application will be described below with some embodiments.

In order to facilitate the understanding of this embodiment, firstly, the test environment in which the battery testing method disclosed in the embodiments of the present application is executed is introduced.

As shown in Fig, 1, which is a schematic diagram of environmental interaction of the environment where a testing system for a battery testing method provided by the embodiments of the present application is located,
the testing system may include an electronic device 110 and a testing device 130. The electronic device 110 is in communication connection with one or more communication devices 120 through a network for data communication or interaction. The electronic device 110 may be a network server, a data base server, a personal computer (PC), a tablet computer, a smart phone, a personal digital assistant (PDA), and the like.

The communication device 120 may be a device mounted on the battery to be tested that can be used for communication, or it may be a communication device to which the battery to be tested is connected.

In one example, the communication device 120 may be a vehicle capable of carrying multiple groups of batteries, wherein the vehicle acts as a communication device for transmitting battery data of batteries to be tested to the electronic device 110.

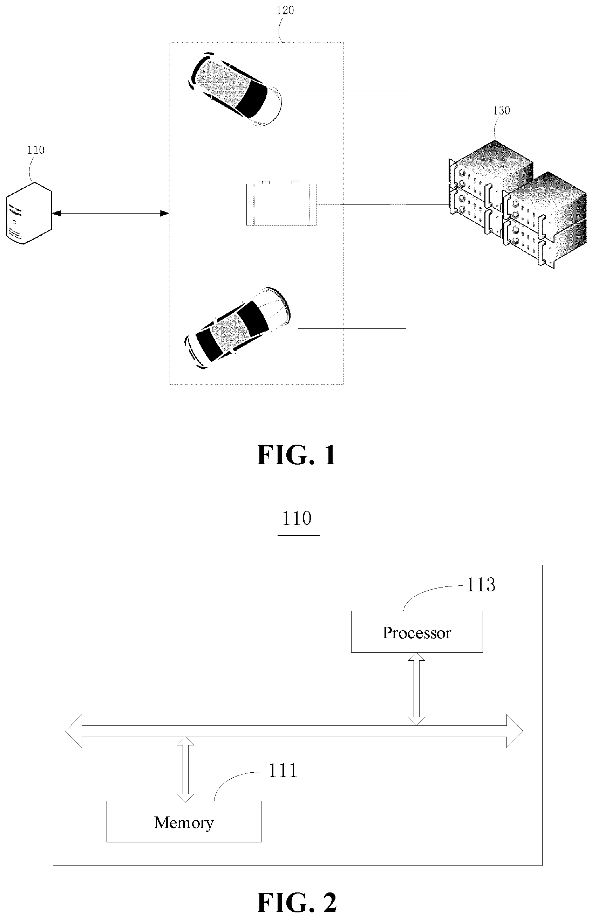

As shown in Fig. 2, which is a schematic block diagram of the electronic device, the electronic device 110 may include a memory 111 and a processor 113. It will be understood by those of ordinary skill in the art that the structure shown in Fig. 2 is only schematic and that it does not limit the structure of the electronic device 110. For example, the electronic device 110 may also include more or fewer components than those shown in Fig. 2, or have a different configuration from that shown in Fig. 2.

The above-mentioned components such as the memory 111 and the processor 113 are directly or indirectly electrically connected with each other so as to realize data transmission or interaction. For example, these components can be electrically connected with each other through one or more communication buses or signal lines. The above-mentioned processor 113 is used for executing the executable modules stored in the memory.

Among them, the memory 111 can be, but is not limited to, a random access memory (RAM), a read only memory (ROM), a programmable read-only memory (PROM), an erasable programmable read-only memory (EPROM), an electric erasable programmable read-only memory (EEPROM), and so on. Among them, the memory 111 is used for storing a program, and the processor 113 executes the program after receiving the an execution instruction. The method executed by the electronic device 110 as defined by the process disclosed in any of the embodiments of the present application may be applied in the processor 113, or implemented by the processor 113.

The above-mentioned processor 113 may be an integrated circuit chip with signal processing capabilities. The above processor 113 may be a general-purpose processor, including a central processing unit (CPU), a network processor (NP), and the like; and it may also be a digital signal processor (DSP), an application specific integrated circuit (ASIC), a field programmable gate array (FPGA) or other programmable logic devices, discrete gates or transistor logic devices, discrete hardware components. The methods, steps, and logical block diagrams as disclosed in embodiments of the present application can be implemented or performed. The general purpose processor may be a microprocessor, or the processor may also be any conventional processor, etc.

The electronic device 110 in this embodiment can be used to perform various steps in various battery testing methods provided by the embodiments of the present application.

This testing device 130 may be connected with the battery to be tested by means of wire connection, and the testing device 130 may also be connected with the vehicle in which the battery to be tested is mounted by means of wire connection.

The testing device 130 can be used for endurance testing of the battery to be tested. Exemplarily, the testing device 130 can be used to implement insulation impedance testing, voltage withstand testing, equipotential testing, short circuit detection, relay function testing, among others. Specifically, depending on the usage scenario, or the testing needs, the testing device 130 can also implement more testing functions required to connect to the battery to be tested.

The test equipment 130 may be an EOL testing device, which may include: an equipotential testing bench, a whole-vehicle testing bench, an AC/DC charging testing bench, an insulation testing bench, a hand-held diagnostic instrument, and so on.

Exemplarily, in the actual usage scenario, the testing device 130 may be configured with a testing station, which may be used for parking a vehicle in which the battery is mounted or for placing the battery to be tested.

Optionally, the testing device 130 is further used for wired connection with the battery to be tested or the vehicle in which the battery to be tested is mounted after obtaining the test result of the battery to be tested from the electronic device 110, so as to perform endurance testing of the battery to be tested.

Optionally, it is possible that, after the test result of the electronic device 110 for the battery to be tested is a test pass, the testing device 130 is further used for wired connection again with the battery to be tested or the vehicle in which the battery to be tested is mounted, so as to perform endurance testing of the battery to be tested. This processing approach allows subsequent tests to be performed only when the wireless test result of the battery to be tested indicates that there is no abnormality in the battery to be tested, thus allowing for a reduction in testing costs and a reduction in useless testing.

Of course, in some scenarios, if a more comprehensive understanding of the state of the battery is required, a complete implementation of the battery test is needed, and the electronic device 110 and the testing device 130 can be used to test different data of the battery to be tested. The embodiments of the present application may not be limited to the test sequence of the electronic device 110 and the testing device 130. For example, it is possible that the electronic device 110 tests the battery to be tested first, and then the testing device 130 tests the battery to be tested. For another example, it is possible that the testing device 130 tests the battery to be tested first, and then the electronic device 110 tests the battery to be tested. Of course, it is also possible that the electronic device 110 tests the battery to be tested during the testing of the battery to be tested by the testing device 130.

The implementation process for the battery testing method that can be executed by the testing system or electronic device 110 described above is described below through several embodiments.

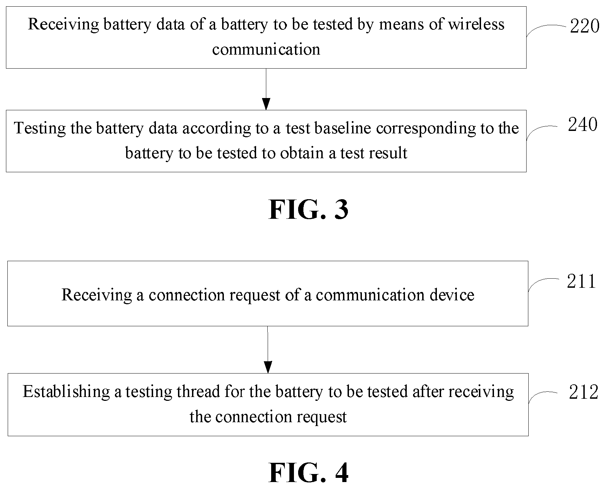

Please refer to Fig. 3, which is a flowchart of a battery testing method provided by the embodiments of the present application. The method in the embodiments of the present application can be applied to an electronic device running a testing program, and the electronic device can perform the steps in the battery testing method in the embodiments of the present application. The specific process shown in Fig. 3 will be described in detail below.

Step 220: receiving battery data of a battery to be tested by means of wireless communication.

Exemplarily, this wireless communication approach may be wireless network communication, wireless short-range communication or other wireless connected communication approaches.

Optionally, there may be a testing client running in the device that sends the battery data, through which it communicates with the server running in the electronic device to enable the transmission of the data required for the test.

The battery data may be data that can characterize the characteristics of the battery to be tested, for example, voltage data and current data of the battery, battery capacity data, battery temperature, and the like.

Step 240: testing the battery data according to a test baseline corresponding to the battery to be tested to obtain a test result.

Exemplarily, the test baseline may be used to characterize a normal baseline for the battery data of the battery to be tested.

Here, if the battery data of the battery to be tested meets this test baseline, it can be indicated that the battery data of the battery to be tested meets the requirement. If the battery data of the battery to be tested does not meet this test baseline, it can be indicated that the battery data of the battery to be tested does not meet the requirement, and this battery to be tested is not suitable for market use.

Optionally, the electronic device can also receive battery data of a plurality of different types of batteries to be tested, so as to separately test the various types of batteries to be tested based on the battery data of the various types of batteries to be tested.

Exemplarily, the electronic device can also receive battery data of a plurality of different types of batteries to be tested, so as to perform parallel testing on the various types of batteries to be tested based on the battery data of the various types of batteries to be tested.

The method described above uses a wireless testing approach to send battery data of the battery to be tested to one end of testing the battery by means of wireless transmission, so that the testing of this battery data can be realized without the need for the battery to be tested or the vehicle in which the battery is mounted to be at the testing station and pulling the wires for the battery or the whole vehicle in which the battery is mounted one by one, thus reducing the need for testing stations for battery testing and also being able to improve the efficiency of battery testing. Further, the electronic device can impose no limitations on the models of batteries to be tested, but can implement testing for various different models of batteries, which can reduce the number of electronic devices required for testing batteries to be tested, and reduce the resources required for testing.

Considering that the battery may need to undergo a relatively large number of items to be tested, in order to obtain test results more accurately for each item to be tested, when the battery data includes at least two items to be tested, the test baseline may include a specification interval corresponding to each item to be tested. Step 240 may include: comparing each item to be tested with the corresponding specification interval in the test baseline to determine a test result for each item to be tested.

Here, if an item to be tested is within the specification interval corresponding to the item to be tested, it means that this item to be tested has passed the test; or if an item to be tested is not within the specification interval corresponding to the item to be tested, it means that this item to be tested has not passed the test.

Exemplarily, the specification interval may be a continuous numerical interval or a discrete interval including one or more single-point numerical values.

Exemplarily, the battery data includes at least one of a maximum voltage of the battery to be tested, a minimum voltage of the battery to be tested, a battery cell voltage difference in the battery to be tested, a maximum temperature of the battery to be tested, a minimum temperature of the battery to be tested, a battery cell temperature difference in the battery to be tested, water inlet and outlet temperatures of the battery to be tested, and a charging port temperature of the battery to be tested.

Optionally, the items to be tested in the above battery data may correspond to one specification interval.

The maximum voltage of the battery to be tested described above may indicate the maximum voltage of all the battery cells in a group of batteries; the minimum voltage of the battery to be tested may indicate the minimum voltage of all the battery cells in a group of batteries; the battery cell voltage difference in the battery to be tested may indicate the difference between the maximum voltage and the minimum voltage of the battery to be tested; the maximum temperature of the battery to be tested may indicate the maximum temperature of all the battery cells in a group of batteries; the minimum temperature of the battery to be tested may indicate the minimum temperature of all the battery cells in a group of batteries; the battery cell temperature difference in the battery to be tested may indicate the difference between the maximum temperature and the minimum temperature of the battery to be tested; the water inlet and outlet temperatures of the battery to be tested indicate the temperature of the water inlet of the water cooling system of the battery to be tested and the temperature of the water outlet of the water cooling system; and the charging port temperature of the battery to be tested may indicate the temperature of the charging port used to charge the battery to be tested. In an example, the battery to be tested is mounted on a vehicle, and the charging port temperature of the battery to be tested may indicate the temperature of the charging port on the vehicle that is used to charge the battery to be tested.

In an example, the specification interval corresponding to the maximum voltage of the battery to be tested may be [3V, 4V]. Of course, for different battery models, the specification interval corresponding to the maximum voltage may also be different.

Exemplarily, the specification interval corresponding to the minimum voltage of the battery to be tested may be the same as the specification interval corresponding to the maximum voltage of the battery to be tested; and the specification interval corresponding to the minimum voltage of the battery to be tested may also be [3V, 4V].

In an example, the critical value of the battery cell voltage difference in the battery to be tested may be 20mV, and the specification interval for the battery cell voltage difference in the battery to be tested may be [0mV, 20mV]. If the test standard is different, the critical value of the battery cell voltage difference in the battery to be tested may also be a larger or smaller value. For example, the critical value of the battery cell voltage difference may be 15mV, 25mV, and the like.

In an example, the specification interval corresponding to the maximum temperature of the battery to be tested may be [5°C, 40°C]. Of course, the specification interval corresponding to the maximum temperature may also be different for different battery models.

Exemplarily, the specification interval corresponding to the minimum temperature of the battery to be tested may be the same as the specification interval corresponding to the maximum temperature of the battery to be tested; and the specification interval corresponding to the minimum temperature of the battery to be tested may also be [5°C, 40°C].

In an example, the critical value of the battery cell temperature difference in the battery to be tested may be 5°C, and the specification interval for the battery cell temperature difference in the battery to be tested may be [0°C, 5°C].

Optionally, the items to be tested in the battery data may also include the number of temperature sensors on the battery to be tested. In one example, the specification interval for the number of temperature sensors on the battery to be tested may be composed of a numerical value, and the specification interval may be 20. Of course, as the number of battery cells in the battery to be tested increases, more temperature sensors can be arranged in the battery to be tested, and the specification interval can be a larger value, for example, 25, 30, etc.

The specification intervals corresponding to the above items to be tested are only illustrative examples, and the specific values of the specification intervals are not limited in the embodiments of the present application, and the specification intervals corresponding to batteries of different types and batteries with different capacities can be different.

In this way, when testing the battery data, different specification intervals can be set based on different items to be tested, and the battery test can be realized more comprehensively.

Optionally, after step 240, the battery testing method further includes sending the test result to a communication device.

The communication device is a device for transmitting the battery data of the battery to be tested, which can be a communication device mounted on the battery to be tested, a vehicle in which the battery to be tested is mounted, or a communication device capable of acquiring data of sensors on the battery to be tested.

After receiving the test result, the communication device can display it on the display interface, so that users can know the current situation of the battery more quickly.

Optionally, the test result may include the test result for each item to be tested in the battery data.

Optionally, the test result may be "passed" or "failed", or it may be the difference between the specific numerical value of the item to be tested and the specification interval.

Optionally, the test result may be displayed on the display unit of the communication device in the form of a table, and may also be displayed on the display unit of the communication device in the form of a text file. Of course, according to the actual needs, the test result may also be output in other forms, for example, the test result may also be output on the communication device in the form of voice, video, and so on.

By retransmitting the test result to the communication device, the user can be informed of the test result, and furthermore, the test result can be displayed in various forms, which can make the test result easier to be presented visually.

The electronic device used for executing the battery testing method of the embodiments of the present application can provide a testing service for each group of batteries to be tested by means of thread construction. As shown in Fig. 4, before step 220, the following steps may be further included.

Step 211: receiving a connection request of a communication device.

Here, the communication device is used for transmitting battery data of the battery to be tested.

Optionally, the connection request may carry relevant information for the communication device. For example, the communication device may be an in-vehicle device on a vehicle, and the connection request may include vehicle information, the number of batteries mounted on the vehicle, and the like.

Step 212: establishing a testing thread for the battery to be tested after receiving the connection request.

This testing thread is used to test the battery to be tested.

Optionally, the battery testing method of the embodiments of the present application can be executed by a testing program running in the electronic device, and then a testing thread can be created by the testing program for checking the battery to be tested.

Optionally, each testing thread can be used for one test of a battery to be tested.

Optionally, this testing thread can perform a test taking a battery to be tested as a unit, one testing thread being used for testing a group of batteries to be tested. Exemplarily, if the communication device is used for sending battery data of multiple groups of batteries to be tested, one testing thread is established separately for each group of batteries to be tested in the multiple groups of batteries to be tested.

Optionally, this testing thread can perform a test taking the communication device as a unit, one testing thread being used for testing all the batteries to be tested sent by one communication device. For example, with respect to a communication device, the communication device may send battery data for a group of batteries to be tested for testing, or it may send battery data of multiple groups of batteries to be tested for testing. Exemplarily, if this communication device is used for sending battery data of multiple groups of batteries to be tested, one testing thread is established for the multiple groups of batteries to be tested.

Optionally, after the battery to be tested that is tested by any testing thread has been tested, this testing thread can be closed.

In this embodiment, if the electronic device receives a connection request for testing various types of batteries to be tested, it can also construct threads separately for different types of batteries to be tested, so as to provide tests for different types of batteries in parallel.

In the above implementation, testing threads can be set for different units to implement the testing by special threads on the corresponding battery to be tested, which can increase the number of batteries to be tested that can be processed and improve the efficiency of battery testing.

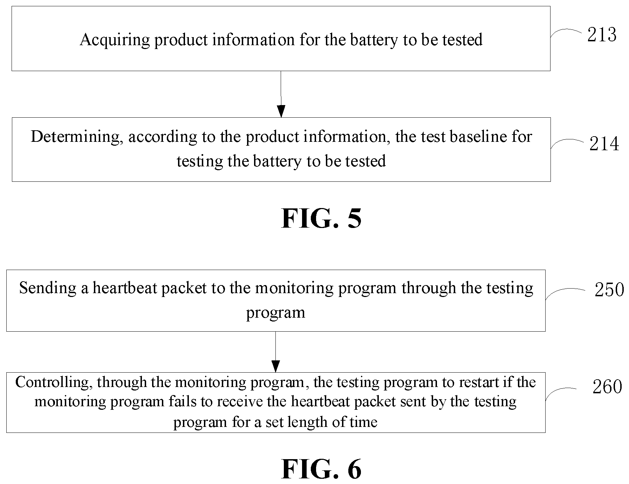

Testing of batteries by the electronic devices in a wireless manner enables testing of more types of batteries and takes into account different test standards required for different types of batteries. Therefore, before testing the battery to be tested, the test baseline to be used for the battery to be tested may also be determined. Based on this, before step 220 or after step 220, as shown in Fig. 5, the battery testing method may further include the following steps.

Step 213: acquiring product information for the battery to be tested.

The product information may include the battery model of the battery to be tested, the identification code of the battery to be tested, the vehicle model to which the battery to be tested is applicable, and any other information that can characterize the battery to be tested.

Optionally, the product information may be obtained before the battery data is received. Exemplarily, the product information for the battery to be tested can be received by means of wireless communication.

Optionally, the product information for the battery to be tested can also be transmitted along with the battery data.

Step 214: determining, according to the product information, the test baseline for testing the battery to be tested.

This test baseline can constitute the test formula used to test batteries.

Optionally, the electronic device can store the test baselines required by a plurality of different types of batteries. Exemplarily, the test baselines stored in the electronic device vary depending on the model of the battery to be tested at the test site. Specifically, according to the actual test scenario, more or less test baselines required by different models of batteries can be stored in the electronic device.

Here, the various test baselines are bound to the various items of battery information one by one. Exemplarily, in the electronic device, the battery information for each model of battery can be stored in association with the corresponding test baseline in the form of a table or other associated storage, so as to form a baseline data base. Based on the battery information, the test baseline corresponding to this battery information is searched out from this baseline data base.

This test baseline may include a DBC (data base can) file required for testing the battery to be tested, items to be tested for the battery to be tested, and specification intervals for various items to be tested.

After determining the test baseline for the battery to be tested, this DBC file can also be read to determine the CAN variable base. This CAN variable base may include a number of variables that may need to be tested. Among them, the amount of data to be tested for the battery to be tested may be the same as the number of variables in the CAN variable base or may be less than the number of variables in this CAN variable base.

The battery data received in step 220 may be presented in the form of CAN data frames and may be parsed according to the CAN data frames to compare the variables in the CAN variable base for assignment and updating, so as to determine one or more items to be tested for the battery to be tested.

Through the above approach, the test baseline corresponding to the battery to be tested can be determined in advance, and the testing of more different types of batteries by an electronic device can be realized.

In order to avoid test abnormalities caused by abnormalities such as the testing program being stuck, it is also possible to monitor the testing program used to test the battery to be tested. Therefore, the battery testing method is applied to an electronic device on which a testing program and a monitoring program are run, the testing program being used for testing the battery to be tested. As shown in Fig. 6, the battery testing method may further include:
Step 250: sending a heartbeat packet to the monitoring program through the testing program.
Step 260: controlling, through the monitoring program, the testing program to restart if the monitoring program fails to receive the heartbeat packet sent by the testing program for a set length of time.

Exemplarily, the set length of time may be a length of time greater than the time interval between two adjacent sending of heartbeat packets.

Optionally, the heartbeat packet is sent to the monitoring program according to a set time pattern through the testing program.

Exemplarily, the set time pattern may be at equal time intervals. This equal time interval can be 100ms, 1S, 3S, etc.

Exemplarily, the set time pattern may also be a plurality of designated time nodes, and the time difference between two adjacent time nodes can be the same or different.

Optionally, it may also be possible to monitor the testing program by means of sending heartbeat packets by the monitoring program to the testing program. Therefore, the battery testing method may include: sending a heartbeat packet to the testing program through the monitoring program; and controlling, through the monitoring program, the testing program to restart if the monitoring program does not receive a response message, which is fed back from the testing program after receiving the heartbeat packet.

Optionally, a TCP communication connection may be established between the monitoring program and the testing program to enable communication between the two programs.

Implementing the monitoring of the testing program by means of transmitting heartbeat packets between the two programs at a certain frequency can increase the frequency of effective battery testing and improve the accuracy of battery testing.

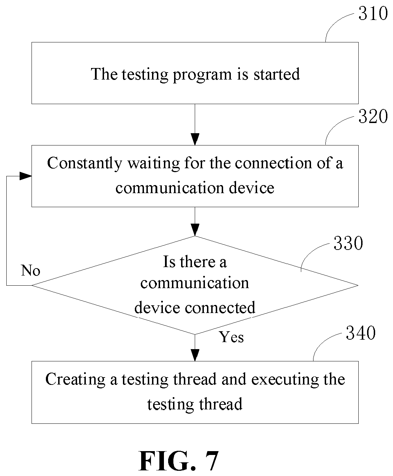

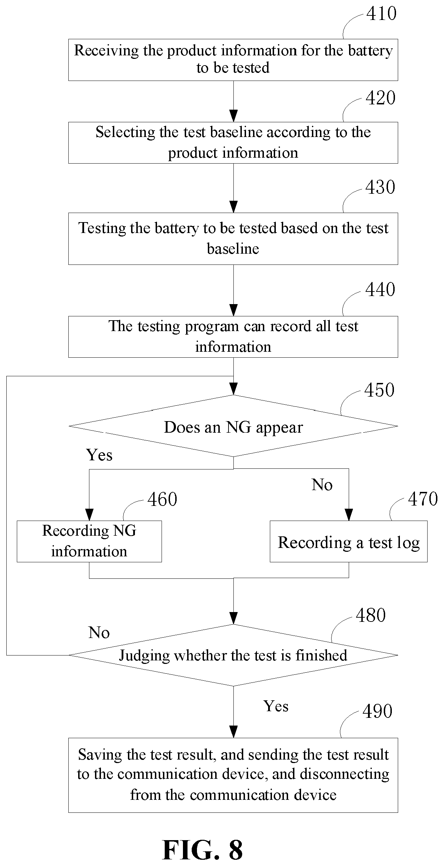

As shown in Fig. 7 and Fig. 8, the following describes the process of testing the battery to be tested through an example:
step 310: the testing program is started;
step 320: constantly waiting for the connection of a communication device;
step 330: is there a communication device connected;
if the testing program is connected by any communication device, executing step 340; and
step 340: creating a testing thread and executing the testing thread.

During the creation or execution of any testing program, the testing program will continue to wait for the connection of the next communication device, and repeat the above steps until the testing program is closed.

Here, when this testing program creates and executes a testing thread, it does not affect the continuation of waiting for other communication devices to connect.

After creating the testing thread, the following steps are performed:
step 410: receiving the product information for the battery to be tested;
step 420: selecting the test baseline according to the product information;
step 430: testing the battery to be tested based on the test baseline; and during the testing, executing step 440;
step 440: the testing program can record all test information;
step 450: does an NG appear;
if an NG appears during the execution of the testing, executing step 460; or if the NG message does not appear, executing step 470;
step 460: recording the NG information;
step 470: recording a test log;
step 480: judging whether the test is finished;
if not, continuing to judge whether an NG appears; or if the test is finished, continuing to execute step 490; and
step 490: saving the test result, and sending the test result to the communication device, and disconnecting from the communication device.

With the above implementation method, it is not necessary to test all the data of the battery to be tested or all the data of the EOL test by means of wire connection, so that the efficiency of battery testing can be improved. Further, testing of the battery to be tested by the testing program in the electronic device can enable the way of parallel testing with multiple testing threads, that is, enable parallel testing of multiple groups of batteries to be tested by one electronic device used for testing, thus reducing the testing pressure of the wire-connected testing approach.

The above steps can be performed by the electronic device, and by means of wireless transmission with the electronic device, the transmission of battery data to the electronic device is realized to achieve the testing of the battery data, and on the basis of achieving testing by means of the above wireless transmission, other wired testing can also be performed on the battery to be tested. For example, the wired testing may include: insulation impedance testing, voltage withstand testing, equipotential testing, short circuit detection, relay function testing.

Exemplarily, the wired testing can be performed by a testing device, which may be an EOL testing device.

Here, wired testing means that the battery to be tested or the vehicle in which the battery to be tested is mounted is in wired connection with the testing device, so as to test the battery to be tested in a wired manner.

In the above implementation, some data of the battery to be tested are tested in a wireless way, and some wired tests of the battery to be tested are conducted in a wired connection way, which can improve the overall testing efficiency of the battery to be tested on the basis of reducing the amount of data required for wired testing.

Based on the same application concept, a battery testing apparatus - not part of the invention - corresponding to the battery testing method may be provided. Since the principle of solving problems by the apparatus is similar to that in the embodiments of the aforementioned battery testing method, reference can be made to the description in the embodiments of the above method for the implementation of such apparatus, without further repetition.

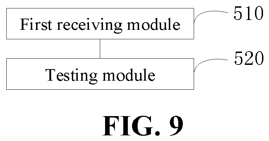

Please refer to Fig. 9, which is a schematic diagram of functional modules of a battery testing apparatus, which does not form part of the invention and is provided for illustrative purposes only. The modules in the battery testing apparatus are used to execute the steps in the above method embodiments. The battery testing apparatus may include: a first receiving module 510 and a testing module 520, wherein the contents of the modules are as follows:
the first receiving module 510 is used for receiving battery data of a battery to be tested by means of wireless communication; and
the testing module 520 is used for testing the battery data according to a test baseline corresponding to the battery to be tested to obtain a test result.

In a possible implementation, the battery data includes at least two items to be tested, and the test baseline includes the specification interval corresponding to each item to be tested; and
the testing module 520 is used for comparing each item to be tested with the corresponding specification interval in the test baseline to determine a test result for each item to be tested.

In a possible implementation, the battery data includes at least one of a maximum voltage of the battery to be tested, a minimum voltage of the battery to be tested, a battery cell voltage difference in the battery to be tested, a maximum temperature of the battery to be tested, a minimum temperature of the battery to be tested, a battery cell temperature difference in the battery to be tested, water inlet and outlet temperatures of the battery to be tested, and a charging port temperature of the battery to be tested.

The battery testing apparatus may further include: a sending module for sending the test result to a communication device, wherein the communication device is a device for transmitting the battery data of the battery to be tested.

The battery testing apparatus may further include:
a second receiving module for receiving a connection request of a communication device, wherein the communication device is used for transmitting the battery data of the battery to be tested; and
an establishment module for establishing a testing thread for the battery to be tested, wherein the testing thread is used for testing the battery to be tested.

In a possible implementation, the establishment module is used for: if the communication device is used for sending battery data of multiple groups of batteries to be tested, establishing one testing thread separately for each group of batteries to be tested in the multiple groups of batteries to be tested; or establishing one testing thread for the multiple groups of batteries to be tested.

The battery testing apparatus may further include:
an acquisition module for acquiring product information for the battery to be tested; and
a determination module for determining, according to the product information, the test baseline for testing the battery to be tested.

In a possible embodiment, the acquisition module is used for receiving the product information for the battery to be tested by means of wireless communication.

The method is applied to an electronic device on which a testing program and a monitoring program are run, the testing program being used for testing the battery to be tested.

The battery testing apparatus may further include: a monitoring module for sending a heartbeat packet to the monitoring program through the testing program; and controlling, through the monitoring program, the testing program to restart if the monitoring program fails to receive the heartbeat packet sent by the testing program for a set length of time.

In a possible implementation, the monitoring module is used for sending the heartbeat packet to the monitoring program according to a set time pattern through the testing program.

In addition, the embodiments of the present application further provide a computer-readable storage medium having a computer program stored thereon, wherein the computer program, when run by a processor, executes the steps of the battery testing method described in the above method embodiments.

The computer program product for the battery testing method provided by the embodiments of the present application includes a computer-readable storage medium in which program codes are stored, and instructions included in the program codes can be used to execute the steps of the battery testing method described in the above method embodiments. For details, please refer to the above method embodiments, which is not repeated here.

In the several embodiments provided in the present application, it should be understood that the disclosed method can also be implemented in other manners. For example, the flowcharts and block diagrams in the drawings show the architecture, functions and operations of possible implementations of the method, and the computer program product according to various embodiments of the present application. In this regard, each block in the flowchart or block diagram may represent one module, a program segment or a part of code, which contains one or more executable instructions for implementing specified logical functions. It should also be noted that in some alternative implementations, the functions noted in the blocks may occur in a different order than those noted in the drawings. For example, two consecutive blocks may actually be executed substantially in parallel, and they may sometimes be executed in the reverse order, depending on the functions involved. It should also be noted that each block of the block diagrams and/or flowchart illustrations, and combinations of blocks in the block diagrams and/or flowchart illustrations, can be implemented by a dedicated hardware-based system that performs the specified functions or actions, or may be implemented by a combination of dedicated hardware and computer instructions.

Furthermore, each functional module in each embodiment of the present application may be integrated together to form a separate part, or each module may exist separately, or two or more modules may be integrated to form a separate part.

If the functions are implemented in the form of software function modules and sold or used as independent products, they can be stored in a computer-readable storage medium. Based on such understanding, the technical solution of the present application, or the part of the technical solution that essentially contributes to the prior art, can be embodied in the form of a software product, wherein this computer software product is stored in a storage medium and includes a number of instructions to cause a computer device (which may be a personal computer, a server, or a network device, etc.) to perform all or some of the steps of the methods described in various embodiments of the present application. The aforementioned storage medium comprises: a USB flash drive, a portable hard disk, a Read-Only Memory (ROM), a Random Access Memory (RAM), a magnetic disk or optical disk and other media that can store program codes. It is noted that herein, relationship terms such as first and second are used only to distinguish one entity or operation from another, and do not necessarily require or imply any such actual relationship or order between those entities or operations. Further, the terms "include," "comprise," or any other variation thereof are intended to cover non-exclusive inclusion, such that a process, method, article, or device that includes a series of elements includes not only those elements, but also other elements not expressly listed, or that also includes elements that are inherent to such a process, method, article, or device. Without further limitation, the elements defined by the phrase "including ..." do not preclude the existence of additional identical elements in the process, method, article, or device in which the elements are included.

The above description is only preferred embodiments of the present application, and is not intended to limit the present application, and for those skilled in the art, the present application may be subjected to various modifications and changes. It should be noted that similar symbols and letters denote similar items in the following accompanying drawings, so that once an item is defined in one of the accompanying drawings, it needs not to be further defined and explained in the subsequent drawings.

What mentioned above is only the specific implementation of the present application, but the scope of protection of the present application is not limited to this, and any person skilled in the art can easily think of variations or substitutions within the technical scope disclosed in the present application, which should be covered by the scope of protection of the present application. Therefore, the protection scope of the present application should be based on the protection scope of the claims.

## Claims

1. A battery testing method, comprising:
receiving battery data of a battery to be tested by means of wireless communication; and
testing the battery data according to a test baseline corresponding to the battery to be tested to obtain a test result;
**characterized in that**
the method is applied to an electronic device (110) on which a testing program and a monitoring program are run, the testing program being used for testing the battery to be tested; and
the method further comprises:
sending a heartbeat packet to the monitoring program through the testing program; and
controlling, through the monitoring program, the testing program to restart if the monitoring program fails to receive the heartbeat packet sent by the testing program for a set length of time.

2. The method according to claim 1, wherein the battery data comprises at least two items to be tested, and the test baseline comprises a specification interval corresponding to each item to be tested; and
said testing the battery data according to a test baseline corresponding to the battery to be tested to obtain a test result comprises:
comparing each item to be tested with the corresponding specification interval in the test baseline to determine a test result for each item to be tested.

3. The method according to claim 1, wherein the battery data comprises at least one of a maximum voltage of the battery to be tested, a minimum voltage of the battery to be tested, a battery cell voltage difference in the battery to be tested, a maximum temperature of the battery to be tested, a minimum temperature of the battery to be tested, a battery cell temperature difference in the battery to be tested, water inlet and outlet temperatures of the battery to be tested, and a charging port temperature of the battery to be tested.

4. The method according to claim 1, wherein the method further comprises:
sending the test result to a communication device (120), wherein the communication device (120) is a device for transmitting the battery data of the battery to be tested.

5. The method according to claim 1, wherein before said receiving battery data of a battery to be tested by means of wireless communication, the method further comprises:
receiving a connection request of a communication device (120), wherein the communication device (120) is used for transmitting the battery data of the battery to be tested; and
establishing a testing thread for the battery to be tested after receiving the connection request, wherein the testing thread is used for testing the battery to be tested.

6. The method according to claim 5, wherein said establishing a testing thread for the battery to be tested comprises:
if the communication device (120) is used for sending battery data of multiple groups of batteries to be tested, establishing one testing thread separately for each group of batteries to be tested in the multiple groups of batteries to be tested; or
establishing one testing thread for the multiple groups of batteries to be tested.

7. The method according to claim 1, wherein the method further comprises:
acquiring product information for the battery to be tested; and
determining, according to the product information, the test baseline for testing the battery to be tested.

8. The method according to claim 7, wherein said acquiring product information for the battery to be tested comprises:
receiving the product information for the battery to be tested by means of wireless communication.

9. The method according to claim 1, wherein sending a heartbeat packet to the monitoring program through the testing program comprises:
sending the heartbeat packet to the monitoring program according to a set time pattern through the testing program.

10. An electronic device (110), comprising: a processor (113) and a memory (111) storing machine-readable instructions that are executable by the processor (113), wherein when the electronic device (110) is run, the machine-readable instructions are executed by the processor (113) to perform the steps of the method according to any one of claims 1 to 9.

11. A computer-readable storage medium, wherein the computer-readable storage medium has a computer program stored thereon, wherein the computer program, when run by a processor (113), causes an electronic device (110) comprising the processor (113) to execute the steps of the method according to any one of claims 1 to 9.

12. A computer program product, comprising computer program instructions, wherein the computer program instructions, when read and run by a processor (113), causes an electronic device (110) comprising the processor (113) to execute the method according to any one of claims 1 to 9.

13. A testing system, comprising an electronic device (110) and a testing device (130), wherein
the electronic device (110) is used for executing the steps in the method according to any one of claims 1 to 9; and
the testing device (130) is used for wired connection with the battery to be tested or a vehicle in which the battery to be tested is mounted, so as to perform an endurance test on the battery to be tested.

14. The testing system according to claim 13, wherein the testing device (130) is further used for wired connection with the battery to be tested or the vehicle in which the battery to be tested is mounted after obtaining the test result of the battery to be tested from the electronic device (110), so as to perform the endurance test on the battery to be tested.

## Patentansprüche

1. Verfahren zur Prüfung einer Batterie, umfassend:
Empfangen von Batteriedaten einer zu prüfenden Batterie mittels Drahtlos-Kommunikation; und
Prüfen der Batteriedaten gemäß einer der zu prüfenden Batterie entsprechenden Prüfbasis, um ein Prüfergebnis zu erhalten;
**dadurch gekennzeichnet, dass**
das Verfahren auf einer elektronischen Vorrichtung (110) angewendet wird, auf der ein Prüfprogramm und ein Überwachungsprogramm ausgeführt werden, wobei das Prüfprogramm zum Prüfen der zu prüfenden Batterie verwendet wird; und
das Verfahren ferner umfasst:
Senden eines Heartbeat-Pakets durch das Prüfprogramm an das Überwachungsprogramm; und
Steuern des Prüfprogramms durch das Überwachungsprogramm derart, dass das Prüfprogramm neu gestartet wird, wenn das Überwachungsprogramm während einer festgelegten Zeitdauer das von dem Prüfprogramm gesendete Heartbeat-Paket nicht empfängt.

2. Verfahren nach Anspruch 1, wobei die Batteriedaten zumindest zwei zu prüfende Elemente umfassen und die Prüfbasis ein jedem zu prüfenden Element entsprechendes Spezifikationsintervall umfasst; und
wobei das Prüfen der Batteriedaten gemäß einer der zu prüfenden Batterie entsprechenden Prüfbasis, um ein Prüfergebnis zu erhalten, umfasst:
Vergleichen jedes zu prüfenden Elements mit dem entsprechenden Spezifikationsintervall in der Prüfbasis, um für jedes zu prüfende Element ein Prüfergebnis zu bestimmen.

3. Verfahren nach Anspruch 1, wobei die Batteriedaten zumindest einen der folgenden Werte umfassen: eine maximale Spannung der zu prüfenden Batterie, eine minimale Spannung der zu prüfenden Batterie, eine Batteriezellenspannungsdifferenz in der zu prüfenden Batterie, eine maximale Temperatur der zu prüfenden Batterie, eine minimale Temperatur der zu prüfenden Batterie, eine Batteriezellentemperaturdifferenz in der zu prüfenden Batterie, eine Wassereinlasstemperatur und eine Wasserauslasstemperatur der zu prüfenden Batterie sowie eine Temperatur eines Ladeanschlusses der zu prüfenden Batterie.

4. Verfahren nach Anspruch 1, wobei das Verfahren ferner umfasst:
Senden des Prüfergebnisses an eine Kommunikationsvorrichtung (120), wobei die Kommunikationsvorrichtung (120) eine Vorrichtung zum Übertragen der Batteriedaten der zu prüfenden Batterie ist.

5. Verfahren nach Anspruch 1, wobei das Verfahren vor dem Empfangen von Batteriedaten einer zu prüfenden Batterie mittels Drahtlos-Kommunikation ferner umfasst:
Empfangen einer Verbindungsanforderung einer Kommunikationsvorrichtung (120), wobei die Kommunikationsvorrichtung (120) zum Übertragen der Batteriedaten der zu prüfenden Batterie verwendet wird; und
Einrichten eines Prüf-Threads für die zu prüfende Batterie nach dem Empfangen der Verbindungsanforderung, wobei der Prüf-Thread zum Prüfen der zu prüfenden Batterie verwendet wird.

6. Verfahren nach Anspruch 5, wobei das Einrichten eines Prüf-Threads für die zu prüfende Batterie umfasst:
wenn die Kommunikationsvorrichtung (120) zum Senden von Batteriedaten mehrerer Gruppen zu prüfender Batterien verwendet wird, gesondertes Einrichten jeweils eines Prüf-Threads für jede Gruppe zu prüfender Batterien der mehreren Gruppen zu prüfender Batterien; oder
Einrichten eines Prüf-Threads für die mehreren Gruppen zu prüfender Batterien.

7. Verfahren nach Anspruch 1, wobei das Verfahren ferner umfasst:
Erfassen von Produktinformationen der zu prüfenden Batterie; und
Bestimmen der Prüfbasis zum Prüfen der zu prüfenden Batterie gemäß den Produktinformationen.

8. Verfahren nach Anspruch 7, wobei das Erfassen von Produktinformationen der zu prüfenden Batterie umfasst:
Empfangen der Produktinformationen der zu prüfenden Batterie mittels Drahtlos-Kommunikation.

9. Verfahren nach Anspruch 1, wobei das Senden eines Heartbeat-Pakets durch das Prüfprogramm an das Überwachungsprogramm umfasst:
Senden des Heartbeat-Pakets durch das Prüfprogramm gemäß einem festgelegten Zeitmuster an das Überwachungsprogramm.

10. Elektronische Vorrichtung (110), umfassend einen Prozessor (113) und einen Speicher (111), in dem maschinenlesbare Anweisungen gespeichert sind, die durch den Prozessor (113) ausführbar sind, wobei beim Betrieb der elektronischen Vorrichtung (110) die maschinenlesbaren Anweisungen durch den Prozessor (113) ausgeführt werden, um die Schritte des Verfahrens nach einem der Ansprüche 1 bis 9 durchzuführen.

11. Computerlesbares Speichermedium, wobei auf dem computerlesbaren Speichermedium ein Computerprogramm gespeichert ist, wobei das Computerprogramm, wenn es durch einen Prozessor (113) ausgeführt wird, bewirkt, dass eine den Prozessor (113) umfassende elektronische Vorrichtung (110) die Schritte des Verfahrens nach einem der Ansprüche 1 bis 9 ausführt.

12. Computerprogrammprodukt, umfassend Computerprogrammanweisungen, wobei die Computerprogrammanweisungen, wenn sie durch einen Prozessor (113) gelesen und ausgeführt werden, bewirken, dass eine den Prozessor (113) umfassende elektronische Vorrichtung (110) das Verfahren nach einem der Ansprüche 1 bis 9 ausführt.

13. Prüfsystem, umfassend eine elektronische Vorrichtung (110) und eine Prüfvorrichtung (130), wobei
die elektronische Vorrichtung (110) zum Ausführen der Schritte des Verfahrens nach einem der Ansprüche 1 bis 9 verwendet wird; und
die Prüfvorrichtung (130) zur kabelgebundenen Verbindung mit der zu prüfenden Batterie oder mit einem Fahrzeug, in dem die zu prüfende Batterie eingebaut ist, verwendet wird, um eine Dauerprüfung an der zu prüfenden Batterie durchzuführen.

14. Prüfsystem nach Anspruch 13, wobei die Prüfvorrichtung (130) ferner dazu verwendet wird, nach dem Erhalten des Prüfergebnisses der zu prüfenden Batterie von der elektronischen Vorrichtung (110) eine kabelgebundene Verbindung mit der zu prüfenden Batterie oder mit dem Fahrzeug, in dem die zu prüfende Batterie eingebaut ist, herzustellen, um die Dauerprüfung an der zu prüfenden Batterie durchzuführen.

## Revendications

1. Procédé de test d'une batterie, comprenant :
la réception, au moyen d'une communication sans fil, de données de batterie d'une batterie à tester ; et
le test des données de batterie conformément à un référentiel de test correspondant à la batterie à tester, afin d'obtenir un résultat de test ;
**caractérisé en ce que**
le procédé est appliqué à un dispositif électronique (110) sur lequel sont exécutés un programme de test et un programme de surveillance, le programme de test étant utilisé pour tester la batterie à tester ; et
le procédé comprend en outre :
l'envoi, par l'intermédiaire du programme de test, d'un paquet de battement de cœur au programme de surveillance ; et
la commande, par l'intermédiaire du programme de surveillance, du redémarrage du programme de test si le programme de surveillance ne reçoit pas, pendant une durée définie, le paquet de battement de cœur envoyé par le programme de test.

2. Procédé selon la revendication 1, dans lequel les données de batterie comprennent au moins deux éléments à tester, et le référentiel de test comprend un intervalle de spécification correspondant à chaque élément à tester ; et
dans lequel ledit test des données de batterie conformément à un référentiel de test correspondant à la batterie à tester, afin d'obtenir un résultat de test, comprend :
la comparaison de chaque élément à tester avec l'intervalle de spécification correspondant dans le référentiel de test, afin de déterminer un résultat de test pour chaque élément à tester.

3. Procédé selon la revendication 1, dans lequel les données de batterie comprennent au moins l'un parmi une tension maximale de la batterie à tester, une tension minimale de la batterie à tester, une différence de tension entre des cellules de batterie dans la batterie à tester, une température maximale de la batterie à tester, une température minimale de la batterie à tester, une différence de température entre des cellules de batterie dans la batterie à tester, des températures d'entrée et de sortie d'eau de la batterie à tester, et une température d'un port de charge de la batterie à tester.

4. Procédé selon la revendication 1, dans lequel le procédé comprend en outre :
l'envoi du résultat de test à un dispositif de communication (120), le dispositif de communication (120) étant un dispositif destiné à transmettre les données de batterie de la batterie à tester.

5. Procédé selon la revendication 1, dans lequel, avant ladite réception, au moyen d'une communication sans fil, de données de batterie d'une batterie à tester, le procédé comprend en outre :
la réception d'une demande de connexion provenant d'un dispositif de communication (120), le dispositif de communication (120) étant utilisé pour transmettre les données de batterie de la batterie à tester ; et
l'établissement d'un fil d'exécution de test pour la batterie à tester après la réception de la demande de connexion, le fil d'exécution de test étant utilisé pour tester la batterie à tester.

6. Procédé selon la revendication 5, dans lequel ledit établissement d'un fil d'exécution de test pour la batterie à tester comprend :
si le dispositif de communication (120) est utilisé pour envoyer des données de batterie de plusieurs groupes de batteries à tester, l'établissement séparé d'un fil d'exécution de test pour chacun des groupes de batteries à tester parmi les plusieurs groupes de batteries à tester ; ou
l'établissement d'un fil d'exécution de test pour les plusieurs groupes de batteries à tester.

7. Procédé selon la revendication 1, dans lequel le procédé comprend en outre :
l'acquisition d'informations de produit relatives à la batterie à tester ; et
la détermination, conformément aux informations de produit, du référentiel de test destiné à tester la batterie à tester.

8. Procédé selon la revendication 7, dans lequel ladite acquisition d'informations de produit relatives à la batterie à tester comprend :
la réception, au moyen d'une communication sans fil, des informations de produit relatives à la batterie à tester.

9. Procédé selon la revendication 1, dans lequel l'envoi, par l'intermédiaire du programme de test, d'un paquet de battement de cœur au programme de surveillance comprend :
l'envoi, par l'intermédiaire du programme de test, du paquet de battement de cœur au programme de surveillance conformément à un schéma temporel défini.

10. Dispositif électronique (110), comprenant un processeur (113) et une mémoire (111) stockant des instructions lisibles par machine qui sont exécutables par le processeur (113), dans lequel, lorsque le dispositif électronique (110) fonctionne, les instructions lisibles par machine sont exécutées par le processeur (113) afin de mettre en œuvre les étapes du procédé selon l'une quelconque des revendications 1 à 9.

11. Support de stockage lisible par ordinateur, dans lequel un programme informatique est stocké sur le support de stockage lisible par ordinateur, le programme informatique, lorsqu'il est exécuté par un processeur (113), amenant un dispositif électronique (110) comprenant le processeur (113) à exécuter les étapes du procédé selon l'une quelconque des revendications 1 à 9.

12. Produit-programme informatique, comprenant des instructions de programme informatique, dans lequel les instructions de programme informatique, lorsqu'elles sont lues et exécutées par un processeur (113), amènent un dispositif électronique (110) comprenant le processeur (113) à exécuter le procédé selon l'une quelconque des revendications 1 à 9.

13. Système de test, comprenant un dispositif électronique (110) et un dispositif de test (130), dans lequel
le dispositif électronique (110) est utilisé pour exécuter les étapes du procédé selon l'une quelconque des revendications 1 à 9 ; et
le dispositif de test (130) est utilisé pour établir une connexion filaire avec la batterie à tester ou avec un véhicule dans lequel la batterie à tester est montée, de manière à effectuer un test d'endurance sur la batterie à tester.

14. Système de test selon la revendication 13, dans lequel le dispositif de test (130) est en outre utilisé pour établir une connexion filaire avec la batterie à tester ou avec le véhicule dans lequel la batterie à tester est montée après avoir obtenu, auprès du dispositif électronique (110), le résultat de test de la batterie à tester, de manière à effectuer le test d'endurance sur la batterie à tester.
